# EUROPEAN PATENT SPECIFICATION

(11) **EP 2 748 903 B1**
(45) Date of publication and mention of the grant of the patent: **22.03.2017**
(21) Application number: 12750802.6
(22) Date of filing: 20.08.2012
(51) Int. Cl.: H01S 5/028, H01S 5/183

(54) **A SEMICONDUCTOR LASER DEVICE AND A METHOD FOR MANUFACTURING A SEMICONDUCTOR LASER DEVICE**
HALBLEITERLASERVORRICHTUNG UND VERFAHREN ZUR HERSTELLUNG EINER HALBLEITERLASERVORRICHTUNG
DISPOSITIF LASER SEMI-CONDUCTEUR ET PROCÉDÉ DE FABRICATION D'UN DISPOSITIF LASER SEMI-CONDUCTEUR

(30) Priority: 23.08.2011 US 201161526642 P; 20.03.2012 GB 201204836
(43) Date of publication of application: 02.07.2014
(73) Proprietor: II-VI Laser Enterprise GmbH, 8045 Zürich (CH)
(72) Inventor: TRAUT, Silke, CH-45702 Niederlenz (CH); SAINTENOY, Stéphanie, CH-8810 Horgen (CH)
(74) Representative: Talbot-Ponsonby, Daniel Frederick
(86) International application number: PCT/GB2012/052030
(87) International publication number: WO 2013/027041

(56) References cited:
- US-A- 5 851 849
- US-A1- 2004 156 410

## Description

### Technical Field

The invention relates to a semiconductor laser device and a method for manufacturing a semiconductor laser device. In particular, the semiconductor laser device may be a vertical cavity surface-emitting laser device (VCSEL) or an edge emitting laser device having a passivation layer for resisting moisture ingress.

### Background

In this specification the term "light" will be used in the sense that it is used in optical systems to mean not just visible light, but also electromagnetic radiation having a wavelength outside that of the visible range.

The vertical cavity surface emitting laser (VCSEL) has become an important light source within many technological fields, such as optical telecommunications and sensing. VCSEL devices are attractive since they can have low threshold currents, low power consumption and high quality far field patterns. Further, VCSEL devices can have a low manufacturing and testing cost due to their small wafer footprint and the ability to perform quality assessment at wafer scale.

A VCSEL device is a semiconductor laser device including one or more semiconductor layers (typically quantum wells) within an active region. The semiconductor layers are typically formed as an epitaxial stack and exhibit an appropriate band gap structure to emit light in a desired wavelength range perpendicularly to the one or more semiconductor layers. Typically, the thickness of a corresponding semiconductor layer is in the range of a few nanometres. In the case of a multi-quantum well laser, the thickness and the strain created during the formation of the stack of semiconductor layers having, in an alternating fashion, a different bandgap, determine the position of the energy level in the quantum wells of the conduction bands and valence bands defined by the layer stack. The position of the energy levels defines the wavelength of the radiation that is emitted by recombination of an electron-hole-pair confined in the respective quantum wells. Unlike in edge emitting semiconductor laser devices, the current flow and the light propagation occurs in a vertical direction with respect to the semiconductor layers. Above and below the semiconductor layers, respective mirrors, also denoted as top and bottom mirrors, wherein the terms "top" and "bottom" are interchangeable, are provided and form a resonator to define an optical cavity. The laser radiation established by the resonator is coupled out through that mirror having the lower reflectivity.

The fabrication process of oxide VCSEL devices involves oxidising a layer in the epitaxial stack through cavities etched in the wafer face to define a lasing area or mesa. This process leaves an entry path for moisture that causes failure in operation. Even though standard passivation layers like SiN or Si₃N₄ deposited by plasma enhanced chemical vapour deposition (PECVD) may provide a moisture resistance sufficient to pass biased standard 85/85 tests the devices show high failure rates in the harsher moisture sensitivity level (MSL-1) test, which includes unbiased preconditioning in wet environment.

The problem is believed to stem from pinholes which form in the passivation layer deposited after oxidation of the oxide layer, through which the moisture can penetrate. Two approaches have previously been suggested to address this problem.

The first approach is to add an additional passivation layer, deposited by a process of PECVD, on top of the standard passivation layer, in the hope that any pinholes in the additional passivation layer will not overlay pinholes in the standard passivation layer. However, devices fabricated using this technique still exhibit a significant failure rate in MSL-1 tests, even if pinholes are not detected. It may be that pinhole detection tests currently in use are not sufficiently sensitive to detect the very smallest pinholes.

The second approach is to utilise "pinhole-free" deposition methods, such as atomic layer deposition (ALD). An example of a film that could be used for a moisture resistance barrier deposited by ALD is the aluminium oxide, Al₂O₃. However, this approach suffers from a problem stemming from the susceptibility of Al₂O₃ to water. The reaction of Al₂O₃ and water is exothermic, resulting in the formation of aluminium hydroxide, Al(OH)₃. This is not desirable for moisture resistant passivation layers. A second problem with the ALD deposition method in general is the slow deposition rate, which can result in an unacceptable increase in the time required to deposit a sufficiently thick layer. US5851849 discloses a process for passivating semiconductor laser structures with severe steps in surface topography.

It would therefore be desirable to provide an improved apparatus and method for inhibiting moisture ingress into VCSEL devices.

### Summary

According to the invention in a first aspect there is provided a semiconductor laser device formed on a semiconductor substrate, the device comprising: a passivation layer arranged on an upper surface of the device structure for resisting moisture ingress, wherein the passivation layer comprises an inner layer comprising a pinhole-free layer of aluminium oxide and deposited on the upper surface of the device by atomic layer deposition and an outer layer deposited on the inner layer by chemical vapour deposition, and comprising a material that is inert in the presence of water.

The use of ALD for the inner layer results in a layer having no pinholes and which therefore provides good moisture resistance. The outer layer shields the inner layer from water and other materials present in the local environment but may be deposited by methods in which pinholes may occur.

A material that is "inert in the presence of water" encompasses a material that has no reaction to water. The material may comprise substances that are not oxidised or reduced in the presence of water. Further, the material may be water repellent. Further still, the material may comprise substances that are immiscible with water.

Optionally, the chemical vapour deposition is plasma-enhanced chemical vapour deposition.

Optionally, the outer layer comprises one of silicon oxynitride, silicon dioxide and silicon nitride.

Optionally, the thickness of the inner layer of the passivation layer is less than the thickness of the outer layer of the passivation layer.

Optionally, the thickness of the inner layer of the passivation layer is in the range from 5 nm to 150 nm.

Optionally, the thickness of the inner layer of the passivation layer is in the range from 5 nm to 15 nm.

Optionally, the thickness of the inner layer of the passivation layer is in the range from 40 nm to 60 nm.

Optionally, the thickness of the inner layer of the passivation layer is in the range from 90 nm to 110 nm.

Optionally, the thickness of the inner layer of the passivation layer is in the range from 3% to 7% of the total passivation layer thickness.

Optionally, the thickness of the inner layer of the passivation layer is in the range from 20% to 30% of the total passivation layer thickness.

Optionally, the thickness of the inner layer of the passivation layer is in the range from 40% to 60% of the total passivation layer thickness.

Optionally, the total thickness of the passivation layer in a region of an emission window of the device is half the wavelength of the light emitted from the device in use.

Optionally, the total thickness of the passivation layer is in the range from 150 nm to 250 nm.

Optionally, the device is a vertical cavity surface emitting laser device, VCSEL.

Optionally, the VCSEL device further comprises: a VCSEL structure comprising doped regions of the semiconductor material forming a resonant cavity disposed between first and second semiconductor mirrors; a mesa formed by one or more oxidation trenches etched at least partially into the second mirror, wherein the upper surface of the VCSEL structure comprises the base of the at least one of the one or more oxidation trenches and the surface of the mesa; and a p-contact deposited on the passivation layer and in contact with the surface of the mesa.

According to the invention in a second aspect there is provided a method for manufacturing a semiconductor laser device formed on a semiconductor substrate, the method comprising: depositing an inner layer of a passivation layer comprising a pinhole-free layer of aluminium oxide on an upper surface of the device by atomic layer deposition, and depositing an outer layer of the passivation layer by chemical vapour deposition on the inner layer, wherein the outer layer comprises material that is inert in the presence of water.

### Brief Description of the Drawings

Some preferred embodiments of the invention will now be described by way of example only, with reference to the accompanying drawings, in which:
Figure 1 is a schematic cross-section view of a VCSEL device;
Figures 2A-2G illustrate the steps in manufacturing a VCSEL device.

### Detailed Description

It has been shown that bulk diffusion is unlikely to be the penetration path for water ingress into a VCSEL device during 85/85 tests. It is more likely that pinholes in a passivation layer are the predominant penetration path. One solution for preventing pinhole diffusion is ALD deposition as ALD deposition results in no pinholes in the deposited material. However, ALD is an expensive process and takes a long time. Further, typical materials deposited by ALD, e.g. aluminium oxides, have an exothermic reaction with water.

Other common methods of providing a passivation layer for preventing moisture ingress to VCSEL devices, chemical vapour deposition (CVD) methods in particular, generate particles in the gas phase that deposit during film growth and lead to pinholes. The provision of two passivation layers deposited by CVD is not completely successful because both passivation layers still contain pinholes.

Stacks of PECVD Si₃N₄ thin films with various in-situ and ex-situ precleaning treatments have been tried. Even though pinhole detection experiments did not reveal any pinholes, there was still a significant failure rate in MSL-1 tests. It appears that the pinhole test has a detection limit above the pinhole size relevant for water vapour penetration. Further, even though the Si₃N₄ PECVD process is a very amorphous process, separate pinholes were not actually overgrown by the second layer but rather pinholes were continued in growth from the first layer. Additionally the oxidized mirror stacks leave etched sidewalls of the mesa with a very rough surface, which is difficult to cover, due to the small aluminium oxide grains of oxidized mirror stacks. Overgrowth and pinhole detection on the etched mesa sidewalls is difficult for all processes, including the Si₃N₄ PECVD process and is possibly the reason for multilayer PECVD stack fails.

As discussed above, a "standard" ALD film that can be used as a moisture resistance barrier is Al₂O₃, where the process is well understood and controlled and the film exhibits low contamination levels. Such films have been compared to PECVD Si₃N₄ films and show superior properties in terms of moisture resistance, but suffer from susceptibility to water and have a slow deposition rate. The thickness of the passivation layer is constrained in the region of the emission window by requirements imposed by the optical properties of the device. Usually, the passivation layer is required to have a thickness of λ/2, or λ/2 plus an integer number of A, where is the wavelength of light emitted by the device. For a typical device, a total physical thickness of about 200 nm to 300 nm may be required, which can take about five hours for one deposition using ALD.

A passivation layer which addresses these problems may be a multilayer scheme having a first layer deposited by ALD to act as a moisture barrier, and a second layer of a dielectric transparent at the laser device emission wavelength. In specific exemplary passivation layers, the fist layer may be aluminium oxide, silicon oxynitride, silicon dioxide or any other material that may be deposited by ALD. Further, the second layer may be deposited by PECVD and may have a thickness sufficient to complete the thickness requirements of the mentioned above. The outer layer should be inert in the presence of water and prevent water from contacting the inner layer. In certain VCSEL designs, the outer layer prevents water from corroding the aluminium oxide used for the inner layer. In specific exemplary VCSELs, the second layer may comprise silicon oxynitride, silicon dioxide or silicon nitride. The second layer may alternatively be deposited by ALD or any other suitable method.

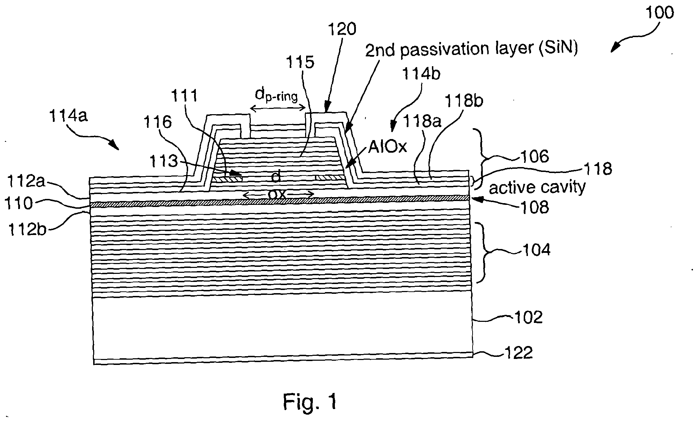

Figure 1 illustrates a schematic cross-section through a VCSEL device 100 formed on a semiconductor material. On a substrate 102 is an n-doped region of semiconductor material forming a first mirror 104. The first mirror 104 is formed by alternating layers of high and low refractive material so as to produce a high reflectivity distributed Bragg reflector (DBR). A p-doped region of semiconductor forms a second mirror 106, also formed as a DBR by alternating high and low refractive index layers. The second mirror 106 is located above the first mirror 104, with a resonant cavity 108 formed therebetween. The resonant cavity 108 includes an active (gain) region comprising one or more quantum well layers 110 separated from the first and second mirrors by barrier layers 112a, 112b. An oxide layer 111 defining an aperture 113 is located between the resonant cavity 108 and the p-mirror 106.

Oxidation trenches 114a, 114b are etched into the second mirror 106. The etched oxidation trenches 114a, 114b form a region of the second mirror 106 into a mesa 115. In exemplary VCSELs, the oxidation trenches 114a, 114b may be connected to form a ring around the mesa 115. In the exemplary VCSEL of Figure 1, the second mirror 106 has been etched through completely to the resonant cavity 108. In other embodiments, the resonant cavity 108 may be etched through, such that the oxidation trenches 114a, 114b extend to the bottom of the barrier layer 112b. In other embodiments, the oxidation trenches 114a, 114b may be etched only partially through the second mirror 106.

The resonant cavity 108 typically has an optical thickness equal to the wavelength λ or an integer number of wavelengths, or a thickness of λ/2 or λ/2 plus an integer number of wavelengths. The material in the barrier layers 112a, 112b of the resonant cavity 108 has a bandgap higher than that of the active area 108. Generally, in the case of λ-resonant cavities, the material of the barrier layers 112a, 112b has a bandgap higher than the bandgap of the active area 110 and lower than the bandgap of the first layer of the first or second DBR 104, 106 respectively. Generally, in the case of an inverse resonant cavity, the material of the barrier layers 112a, 112b has a bandgap greater than the bandgap of the active area 110 and the first layer of the first or second DBR 104, 106 respectively. In any case the resonant cavity 108 contains an active area 110 with a low bandgap relative to the bandgap of the barrier layers 112a, 112b, so there are many carriers.

VCSEL devices 100 for wavelengths from 650 nm to 1300 nm are typically based on gallium arsenide (GaAs) wafers with DBRs formed from GaAs and aluminium gallium arsenide (AlₓGa₍₁₋ₓ₎As). The GaAs-AlGaAs system is favoured for constructing VCSEL devices because the lattice constant of the material does not vary strongly as the composition is changed, permitting multiple "lattice-matched" epitaxial layers to be grown on a GaAs substrate. However, the refractive index of AlGaAs does vary relatively strongly as the Al fraction is increased, minimizing the number of layers required to form an efficient Bragg mirror compared to other candidate material systems. Furthermore, at high aluminium concentrations, an oxide can be formed from AlGaAs, and this oxide can be used to restrict the current in a VCSEL device, enabling very low threshold currents.

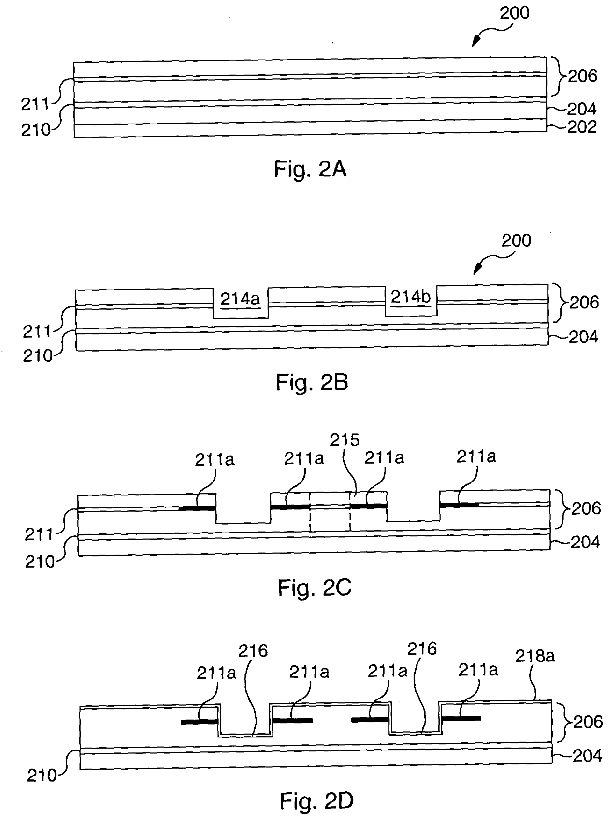

A VCSEL structure is shown in Figures 2A-2G and comprises upper and lower semiconductor mirrors and an active region disposed therebetween. The term "upper surface" is used herein to define the surface of the VCSEL structure that is uppermost before the application of any passivation layers. In the exemplary VCSEL device of Figure 1, the upper surface may be formed by the base 116 of the oxidation trenches 114a, 114b and the surface of the mesa 115.

Deposited on the upper surface of the VCSEL structure is a passivation layer 118. The passivation layer 118 is arranged on the upper surface to prevent moisture ingress to the VCSEL device 100. Specifically, the passivation layer 118 is arranged on the upper surface to prevent moisture ingress to the layers of the VCSEL device 100 providing critical paths for moisture to enter the device. These layers include the oxide layer 111 defining the oxide aperture 113 and all the layers of the second mirror 106 that contain aluminium and are therefore unintentionally oxidised during manufacture of the VCSEL device.

The passivation layer 118 comprises at least two layers; an inner layer 118a, and an outer layer 118b. The inner layer 118a is deposited on the upper surface of the VCSEL structure by ALD. The outer layer 118b is deposited on the inner layer 118a by CVD. In the specific VCSEL device of Figure 1, the outer layer 118b has been deposited on the inner layer 118a by PECVD.

The inner layer 118a comprises a moisture resistant material deposited by ALD so as to minimise the number pinholes. In the exemplary VCSEL device of Figure 1, the first layer 118a comprises aluminium oxide, specifically Al₂O₃. The outer layer 118b comprises silicon nitride, specifically Si₃N₄.

A p-contact 120 is deposited on the passivation layer 118. The p-contact defines an emission window through which light is emitted from the VCSEL device 100. An n-contact 122 is deposited on the substrate 102.

The inner layer 118a of the passivation layer 118 provides a moisture resistant barrier preventing ingress of moisture to the VCSEL device 100. Because the inner layer 118a is deposited by ALD there are no pinholes and so no moisture can penetrate the inner layer 118a. ALD is typically undertaken with aluminium oxide and, more specifically, AL₂O₃, which has an exothermic reaction with water to produce Al(OH)₃. Such a reaction is undesirable in a passivation layer. Therefore, in the exemplary VCSEL device 100 of Figure 1, the outer layer 118b is provided to protect the inner layer 118a from direct contact with water or any other chemicals. The outer layer is deposited by CVD. As the outer layer 118b is deposited using CVD, which is a faster process than ALD, the thickness requirements of the passivation layer 118 of the VCSEL device 100 may be achieved more quickly without compromising its moisture resistance capabilities.

The inner layer 118a has a thickness less than the outer layer 118b. As the ALD process of the inner layer 118a is slow relative to the CVD process of the outer layer 118b, the thickness of the inner layer 118a may be reduced to minimise the manufacturing time of the VCSEL device 100. The thickness of the inner layer 118a may be in the range from 5 nm to 150 nm. In exemplary VCSEL devices, the thickness of the inner layer 118a may be in the range from 5 nm to 15 nm, specifically the thickness may be 10 nm. In other exemplary VCSEL devices, the thickness of the inner layer 118a may be in the range from 40 nm to 60 nm, specifically the thickness may be 50 nm. In other exemplary VCSEL devices, the thickness of the inner layer 118a may be in the range from 90 nm to 110 nm, specifically the thickness may be 100 nm. In other exemplary VCSEL devices, the thickness of the inner layer 118a may be in the range from 15 nm to 40 nm. In other exemplary VCSEL devices, the thickness of the inner layer 118a may be in the range from 60 nm to 90 nm

The thickness of the inner layer 118a may also be expressed as a percentage of the total thickness of the passivation layer 118. As such, in exemplary VCSEL devices, the thickness of the inner layer 118a may be in the range from 3% to 7%, or specifically may be 5%, of the total passivation layer 118 thickness. In other exemplary VCSEL devices, the thickness of the inner layer 118a may be in the range from 20% to 30%, or specifically may be 25%, of the total passivation layer 118 thickness. In other exemplary VCSEL devices, the thickness of the inner layer 118a may be in the range from 40% to 60%, or specifically may be 50%, of the total passivation layer 118 thickness.

The total thickness of the passivation layer 118 in the region of the emission window may be λ/2, i.e. half the wavelength of the light emitted from the VCSEL device 100, or λ/2 plus an integer number of λ. In embodiments, the thickness of the passivation layer 118 in the region of the emission window may be in the range from 150 nm to 250 nm. In other embodiments, the thickness of the passivation layer 118 in the region of the emission window may be 228 nm, wherein the inner layer 118a has a thickness of 10 nm, 50 nm or 100 nm and the outer layer 118b has a thickness sufficient to cover the remainder of the thickness of the passivation layer 118. The thickness of the passivation layer 118 in the region of the emission window may be amended to be different from λ/2 or λ/2 plus an integer number of λ to meet the optical requirements of the device. For the avoidance of doubt, it is noted that passivation layer 118 may be any thickness outside the region of the emission window.

Figures 2A-2G illustrate an exemplary process suitable for manufacturing a VCSEL device 100 with a moisture barrier layer. Figure 2A illustrates a starting material 200 for fabricating a VCSEL device 100 on a substrate 202, which may be of GaAs, for example. The VCSEL structure comprises an active layer 210 sandwiched between lower (first) and upper (second) distributed Bragg reflectors (DBR) 204, 206, each formed by alternating layers having different refractive indices. These layers may be of AlGaAs at different aluminium mole fractions. The lower DBR 204 is typically n-doped and the upper 206 p-doped. An oxide layer 211 is included in the upper DBR 206, which may be of AlGaAs at a high aluminium mole fraction.

The structure 200 is etched to form one or more oxidation trenches 214a, 214b, as shown in Figure 2B, which in turn form a mesa 215. The oxidation trenches 214a, 214b extend into the top DBR 206 past the oxidation layer 211, and are formed around a region which will eventually form the lasing area of the resulting VCSEL device 100. A nitride mask may be applied to the upper DBR before etching to define the areas of the oxidation trenches 214a, 214b, which may be formed by either wet or dry etch. In Figure 2B, the upper DBR 206 has been partially etched away at the oxidation trenches 214a, 214b.

The structure 200 is then placed in an oxidation oven. The structure 200 may be placed in the oven in a "naked" state, i.e. with no masking layers present on the structure 200. Alternatively, the nitride mask may remain in position during this stage of manufacture to prevent oxidation of the top surface of the upper DBR 206. Steam is introduced to the oxidation trenches 214a, 214b and the oxidation layer 211 oxidises laterally producing insulation regions 211 a, which form an aperture 213 as shown in Figure 2C. This process may be termed "wet oxidation".

As shown in Figure 2D, an inner layer 218a of a passivation layer 218 is arranged on an outer surface of the VCSEL structure 200. The inner layer 218a is deposited by a process of ALD. In the example of Figures 2A-2G the outer surface of the VCSEL structure comprises the base 216 of the oxidation trenches 214a, 214b and the surface of the mesa 215. The inner layer 218a may comprise aluminium oxide.

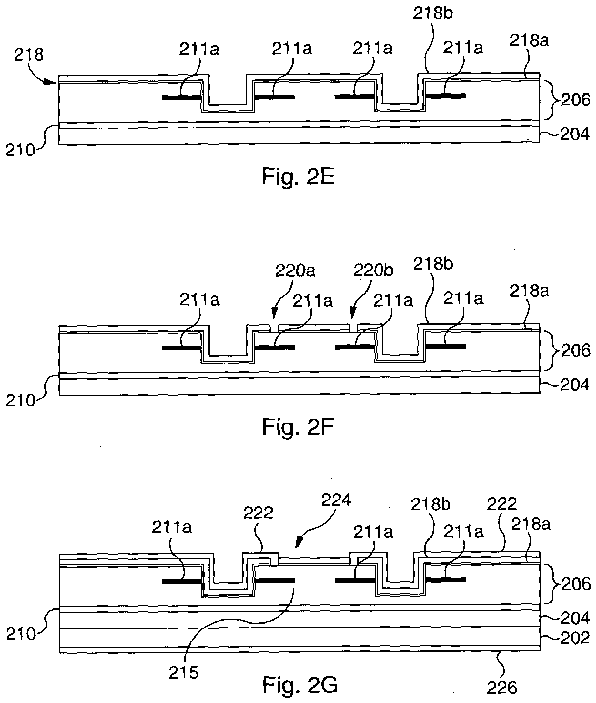

As shown in Figure 2E, a surface of the inner layer 218a is then coated with an outer layer 218b of the passivation layer 218 by a process of CVD. In specific embodiments the process of depositing the outer layer 218b may be PECVD. In alternative embodiments, the outer layer 218b may be deposited by another method, such as ALD.

The inner layer 218a is deposited to provide a moisture barrier, and the outer layer 218b is deposited to make the total thickness of the passivation layer 218 up to λ/2 (or λ/2 plus an integer number of λ). As the CVD process is faster than the ALD process, it will often be more practical for the inner layer 218a to be thinner than the outer layer 218b. The thicknesses of the inner layer 218a and the outer layer 218b are discussed above in relation to Figure 1.

As shown in Figure 2F, at trenches 220a, 220b are etched through the passivation layer 218a, 218b to expose the upper surface of the mesa 215. This allows a p-contact 222 to be deposited on the VCSEL structure such that it is in contact with the mesa 215. In the region of the emission window 224, through which light is emitted from the device, the thickness of the passivation layer conforms to the design requirements discussed above.

In Figure 2G a metal p-contact 222 is deposited onto the passivation layer and down through the trenches 220a, 220b to contact the upper surface of the mesa 215. In addition, an n-contact 226 is deposited on the lower surface of the substrate 202.

In alternative embodiments, the method of manufacturing a VCSEL device may comprise a combined step of oxidising the oxidation layer 211 and depositing the inner layer 218a of the passivation layer 218 in a single vessel. The combination of these two steps in a single vessel ensures that the inner layer 218a completely covers a semiconductor wafer comprising a plurality of VCSEL structures, and reduces the risk of contamination of the VCSEL structures between oxidation and ALD deposition of the inner layer 218a.

The structure described above makes it possible to fabricate VCSEL lasers with high moisture resistance which can be used, for example, in cell phone applications.

Other VCSEL devices may be envisaged without departing from the scope of the appended claims. For example, in an exemplary VCSEL device, the outer layer may comprise silicon oxynitride, silicon dioxide or silicon nitride deposited by CVD. In other exemplary VCSEL devices, the inner layer may comprise silicon dioxide deposited by ALD. In other exemplary VCSEL devices, the inner layer and outer layer may both be deposited by ALD. In such devices, the inner layer may comprise silicon dioxide or aluminium oxide, and the outer layer may comprise silicon dioxide.

While the foregoing is directed to embodiments of the present invention, other and further embodiments of the invention may be devised without departing from the basic scope thereof, which is determined by the claims that follow.

## Claims

1. A semiconductor laser device (100) formed on a semiconductor substrate (102), the device comprising:
a passivation layer (118) arranged on an upper surface of the device structure for resisting moisture ingress,
**characterised in that** the passivation layer comprises an inner layer (118a) comprising a pinhole-free layer of aluminium oxide and deposited on the upper surface of the device by atomic layer deposition and an outer layer (118b) deposited on the inner layer by chemical vapour deposition, and comprising a material that is inert in the presence of water.

2. A device (100) according to claim 1, wherein the chemical vapour deposition is plasma-enhanced chemical vapour deposition.

3. A device (100) according to claim 1 or 2, wherein the outer layer (118b) comprises one of silicon oxynitride, silicon dioxide and silicon nitride.

4. A device (100) according to any preceding claim, wherein the thickness of the inner layer (118a) of the passivation layer is less than the thickness of the outer layer (118b) of the passivation layer.

5. A device (100) according to any preceding claim, wherein the thickness of the inner layer (118a) of the passivation layer is in the range from 5 nm to 150 nm, in the range from 5 nm to 15 nm, in the range from 40 nm to 60 nm, or is in the range from 90 nm to 110 nm.

6. A device (100) according to any preceding claim, wherein the thickness of the inner layer (118a) of the passivation layer is in the range from 3% to 7% of the total passivation layer (118) thickness, in the range from 20% to 30% of the total passivation layer thickness, or in the range from 40% to 60% of the total passivation layer thickness.

7. A device (100) according to any preceding claim, wherein the total thickness of the passivation layer (118) in a region of an emission window of the device is half the wavelength of the light emitted from the device in use.

8. A device (100) according to any preceding claim, wherein the total thickness of the passivation layer (118) is in the range from 150 nm to 250 nm.

9. A device (100) according to any preceding claim, wherein the device is a vertical cavity surface emitting laser device, VCSEL.

10. A VCSEL device (100) according to claim 9, further comprising
a VCSEL structure comprising doped regions of the semiconductor material forming a resonant cavity disposed between first and second semiconductor mirrors;
a mesa formed by one or more oxidation trenches etched at least partially into the second mirror, wherein the upper surface of the VCSEL structure comprises the base of the at least one of the one or more oxidation trenches and the surface of the mesa; and
a p-contact deposited on the passivation layer and in contact with the surface of the mesa.

11. A method for manufacturing a semiconductor laser device (100) formed on a semiconductor substrate, the method comprising and **characterised by**:
depositing an inner layer of a passivation layer (118a) comprising a pinhole-free layer of aluminium oxide on an upper surface of the device by atomic layer deposition, and depositing an outer layer of the passivation layer (118b) by chemical vapour deposition on the inner layer, wherein the outer layer comprises material that is inert in the presence of water.

## Patentansprüche

1. Halbleiterlaservorrichtung (100), gebildet auf einem Halbleitersubstrat (102), beinhaltend:
eine Passivierungsschicht (118), angeordnet auf einer oberen Fläche der Vorrichtungsstruktur zur Abwehr von Feuchtigkeitseintritt,
**dadurch gekennzeichnet, dass** die Passivierungsschicht eine innere Schicht (118a) enthält, die eine nadellochfreie Schicht aus Aluminiumoxid enthält, welche auf der oberen Fläche der Vorrichtung durch Atomlagenbeschichtung aufgebracht wird und eine äußere Schicht (118b), die auf der inneren Schicht durch chemischen Dampfauftrag aufgebracht wird, und die ein Material enthält, das in Gegenwart von Wasser inert ist.

2. Vorrichtung (100) nach Anspruch 1, bei welcher der chemische Dampfauftrag ein plasmagestützter chemischer Dampfauftrag ist.

3. Vorrichtung (100) nach Anspruch 1 oder 2, bei welcher die äußere Schicht (118b) eine der Komponenten Oxinitrid, Silikondioxid und Silikonnitrid enthält.

4. Vorrichtung (100) nach einem der der vorherigen Ansprüche, bei welcher die Dicke der inneren Schicht (118a) der Passivierungsschicht geringer ist als die Dicke der äußeren Schicht (118b) der Passivierungsschicht.

5. Vorrichtung (100) nach einem der vorherigen Ansprüche, bei welcher die Dicke der inneren Schicht (118a) der Passivierungsschicht in dem Bereich von 5 nm bis 150 nm, in dem Bereich von 5 nm bis 15 nm, in dem Bereich von 40 nm bis 60 nm oder in dem Bereich von 90 nm bis 110 nm liegt.

6. Vorrichtung (100) nach einem der vorherigen Ansprüche, bei welcher die Dicke der inneren Schicht (118a) der Passivierungsschicht in dem Bereich von 3 % bis 7 % der Gesamtdicke der Passivierungsschicht (118), in dem Bereich von 20 % bis 30 % der Gesamtdicke der Passivierungsschicht, oder in dem Bereich von 40 % bis 60 % der Gesamtdicke der Passivierungsschicht liegt.

7. Vorrichtung (100) nach einem der vorherigen Ansprüche, bei welcher die Gesamtdicke der Passivierungsschicht (118) im Bereich eines Emissionsfensters der Vorrichtung die halbe Wellenlänge des von der Vorrichtung in Betrieb emittierten Lichts beträgt.

8. Vorrichtung (100) nach einem der vorherigen Ansprüche, bei welcher die Gesamtdicke der Passivierungsschicht (118) in dem Bereich von 150 nm bis 250 nm liegt.

9. Vorrichtung (100) nach einem der vorherigen Ansprüche, bei welcher die Vorrichtung eine vertikal-Hohlraum-oberflächenemittierende Laservorrichtung, VCSEL, ist.

10. VCSEL-Vorrichtung (100) nach Anspruch 9, weiterhin beinhaltend:
eine VCSEL-Struktur, beinhaltend gedopte Bereiche des Halbleitermaterials, die einen Resonanzhohlraum bilden, der zwischen dem ersten und dem zweiten Halbleiterspiegel angeordnet ist;
eine Mesa, gebildet aus einem oder mehreren Oxidationsgräben, die zumindest teilweise in den zweiten Spiegel geätzt sind, wobei die obere Fläche der VCSEL-Struktur die Basis von dem mindestens einen von dem einen oder mehreren Oxidationsgräben und der Oberfläche der Mesa bildet; und
einen p-Kontakt, der auf der Passivierungsschicht in Kontakt mit der Oberfläche der Mesa aufgebracht ist.

11. Verfahren zur Herstellung einer Halbleiterlaservorrichtung (100), bestehend aus einem Halbleitersubstrat, enthaltend und **gekennzeichnet durch**:
den Auftrag einer inneren Schicht einer Passivierungsschicht (118a), beinhaltend eine durch Atomlagenbeschichtung aufgebrachte nadellochfreie Schicht aus Aluminiumoxid auf einer oberen Fläche der Vorrichtung und den Auftrag einer äußeren Schicht der Passivierungsschicht (118b) **durch** chemischen Dampfauftrag auf der inneren Schicht, wobei die äußere Schicht ein Material enthält, das in Gegenwart von Wasser inert ist.

## Revendications

1. Dispositif laser semi-conducteur (100) formé sur un substrat semi-conducteur (102), le dispositif comprenant :
une couche de passivation (118) agencée sur une surface supérieure de la structure du dispositif afin de résister à une intrusion d'humidité,
**caractérisé en ce que** la couche de passivation comprend une couche interne (118a) comprenant une couche d'oxyde d'aluminium exempte de piqûres et déposée sur la surface supérieure du dispositif par dépôt de couche atomique et une couche externe (118b) déposée sur la couche interne par dépôt chimique en phase vapeur, et comprenant un matériau qui est inerte en présence d'eau.

2. Dispositif (100) selon la revendication 1, dans lequel le dépôt chimique en phase vapeur est un dépôt chimique en phase vapeur activé par plasma.

3. Dispositif (100) selon la revendication 1 ou 2, dans lequel la couche externe (118b) comprend un parmi de l'oxynitrure de silicium, du dioxyde de silicium, et du nitrure de silicium.

4. Dispositif (100) selon l'une quelconque des revendications précédentes, dans lequel l'épaisseur de la couche interne (118a) de la couche de passivation est inférieure à l'épaisseur de la couche externe (118b) de la couche de passivation.

5. Dispositif (100) selon l'une quelconque des revendications précédentes, dans lequel l'épaisseur de la couche interne (118a) de la couche de passivation se situe dans la plage comprise entre 5 nm et 150 nm, de manière préférée dans la plage comprise entre 5 nm et 15 nm, de manière plus préférée dans la plage comprise entre 40 nm et 60 nm, ou se situe de la manière la plus préférée dans la plage comprise entre 90 nm et 110 nm.

6. Dispositif (100) selon l'une quelconque des revendications précédentes, dans lequel l'épaisseur de la couche interne (118a) de la couche de passivation se situe de manière préférée dans la plage comprise entre 3% et 7% de l'épaisseur totale de la couche de passivation (118), de manière plus préférée dans la plage comprise entre 20% et 30% de l'épaisseur totale de la couche de passivation, ou de la manière la plus préférée dans la plage comprise entre 40% et 60% de l'épaisseur totale de la couche de passivation.

7. Dispositif (100) selon l'une quelconque des revendications précédentes, dans lequel l'épaisseur totale de la couche de passivation (118) dans une région d'une fenêtre d'émission du dispositif représente la moitié de la longueur d'onde de la lumière émise par le dispositif en cours d'utilisation.

8. Dispositif (100) selon l'une quelconque des revendications précédentes, dans lequel l'épaisseur totale de la couche de passivation (118) se situe dans la plage comprise entre 150 nm et 250 nm.

9. Dispositif (100) selon l'une quelconque des revendications précédentes, dans lequel le dispositif est un dispositif laser à cavité verticale émettant par la surface, VCSEL.

10. Dispositif VCSEL (100) selon la revendication 9, comprenant en outre :
une structure VCSEL comprenant des régions dopées du matériau semi-conducteur formant une cavité résonnante agencée entre des premier et deuxième miroirs à semi-conducteur ;
une mesa formée par une ou plusieurs tranchée(s) d'oxydation gravée(s) au moins partiellement dans le deuxième miroir, dans lequel la surface supérieure de la structure VCSEL comprend la base de la au moins une parmi la ou les tranchée(s) d'oxydation et la surface de la mesa ; et
un contact de type p déposé sur la couche de passivation et en contact avec la surface de la mesa.

11. Procédé de fabrication d'un dispositif laser semi-conducteur (100) formé sur un substrat semi-conducteur, le procédé comprenant et étant **caractérisé par** les étapes consistant à :
déposer une couche interne d'une couche de passivation (118a) comprenant une couche d'oxyde d'aluminium exempte de piqûres sur une surface supérieure du dispositif par dépôt de couche atomique, et déposer une couche externe de la couche de passivation (118b) par dépôt chimique en phase vapeur sur la couche interne, la couche externe comprenant un matériau qui est inerte en présence d'eau.
